# EUROPÄISCHE PATENTSCHRIFT

(11) **EP 1 597 193 B1**
(45) Veröffentlichungstag und Bekanntmachung des Hinweises auf die Patenterteilung: **25.02.2015**
(21) Anmeldenummer: 03782094.1
(22) Anmeldetag: 06.11.2003
(51) Int. Cl.: B81C 1/00

(54) **VERFAHREN ZUR HERSTELLUNG EINES BAUELEMENTS MIT EINEM HALBLEITERTRÄGER**
METHOD FOR THE PRODUCTION OF A COMPONENT COMPRISING A SEMICONDUCTOR CARRIER
PROCEDE DE FABRICATION D'UN COMPOSANT COMPORTANT UN SUPPORT A SEMICONDUCTEURS

(30) Priorität: 14.02.2003 DE 10306129
(43) Veröffentlichungstag der Anmeldung: 23.11.2005
(73) Patentinhaber: ROBERT BOSCH GMBH, 70442 Stuttgart (DE)
(72) Erfinder: FISCHER, Frank, 72810 Gomaringen (DE); PANNEK, Thorsten, 70176 Stuttgart (DE); METZGER, Lars, 72458 Albstadt (DE)
(86) Internationale Anmeldenummer: PCT/DE2003/003688
(87) Internationale Veröffentlichungsnummer: WO 2004/071944

(56) Entgegenhaltungen:
- EP-A- 1 128 435
- WO-A-02/081363
- US-A- 5 231 878
- US-A1- 2002 182 787
- US-B1- 6 359 276
- KALTSAS G ET AL: "Novel C-MOS compatible monolithic silicon gas flow sensor with porous silicon thermal isolation" SENSORS AND ACTUATORS A, ELSEVIER SEQUOIA S.A., LAUSANNE, CH, Bd. 76, Nr. 1-3, 30. August 1999 (1999-08-30), Seiten 133-138, XP004184426 ISSN: 0924-4247
- LANG W ET AL: "POROUS SILICON TECHNOLOGY FOR THERMAL SENSORS" SENSORS AND MATERIALS, SCIENTIFIC PUBLISHING DIVISION OF MYU, TOKYO, JP, Bd. 8, Nr. 6, 1996, Seiten 327-344, XP000609408 ISSN: 0914-4935

## Beschreibung

Die Erfindung betrifft ein Verfahren zur Herstellung eines Bauelements mit einem Halbleiterträger.

### Stand der Technik:

Zur Herstellung von Bauelementen basierend auf thermischen Effekten werden meist Verfahren in Bulk-Mikro-Mechanik (BMM) verwendet. Hierzu sind aufwändige und teure Ätztechniken erforderlich, um durch rückseitiges Ätzen durch einen kompletten Halbleiterwafer hindurch auf der Vorderseite des Wafers eine dünne Membran freilegen zu können, die zu thermischen Entkopplung von darauf angebrachten Strukturen dient.

Alternativ hierzu kommen die beiden nachstehenden Verfahren zum Einsatz:
a) oxidiertes poröses Silizium (OxPorSi) und
b) oxidierte Siliziumstege (OXOMM steht für oxidierte Oberflächenmechanik).

Bei beiden Alternativen handelt es sich um Prozesse zur thermischen Entkopplung, die auf reine Vorderseitenprozesse beschränkt sind. Die Verfahren haben den Vorteil einer höheren mechanischen Stabilität des thermisch entkoppelten Bereichs und damit einer höheren Gesamtstabilität des Bauelements.

Beim "OxPorSi"-Verfahren wird eine vergleichsweise dicke und schlecht Wärme leitende (0,3 bis 1 W/mK) poröse Siliziumschicht erzeugt, die zusätzlich auch oxidiert werden kann. Derartige Schichten werden z.B. zur thermischen Entkopplung von Sensor- oder Aktorstrukturen in thermischen Bauelementen, wie thermischen, chemischen, fluidischen Sensoren bzw. Gassensoren eingesetzt.

Aus der deutschen Offenlegungsschrift DE 100 58 009 A1 ist ein Strömungssensor, insbesondere zur Analyse von Gasströmungen bekannt, der einen Tragkörper und mindestens ein auf eine Strömung eines Medium sensitives Sensorbauelement aufweist. Das Sensorbauelement ist zumindest bereichsweise von dem Tragkörper durch einen porösen Siliziumbereich oder einen porösen Siliziumoxidbereich getrennt.

Aus der EP 1 128 435 A2 ist ein elektrisches Mikrowellenelement bekannt, bei dem eine Struktur aus porösem Silizium auf einem Siliziumsubstrat zur Ausbildung des elektrischen Elements ausgebildet ist. Die Struktur wird dabei mittels thermischer Oxidation erzeugt.

Aus der US 5,231,878 A ist ein mikromechanischer Luftmassensensor bekannt, bei dem auf einem Siliziumsubstrat ein Dünnschichtwiderstand über der Öffnung für den Luftstrom angeordnet ist.

Aus der US 6,359,276 B1 ist ein auf Infrarotbasis arbeitendes Mikrobolometer bekannt, das eine Brücke aus porösem Silizium aufweist. Der Herstellungschritt, dass Vertiefungen mit einer Deckschicht verschlossen werden ist nicht offenbart.

Aus der US 2002/182787 A1 ist eine Transistor-Halbleiterstruktur bekannt, bei der eine untere und eine obere Silizium-Musterstruktur durch eine Isolationsschicht voneinander getrennt sind. Zur elektrischen Verbindung ist eine Kanalregion aus porösem Silizium vorgesehen. Es ist auch ein entsprechendes Herstellungsverfahren gezeigt.

Bei der Herstellung von porösen Halbleitern, beispielhaft porösem Silizium, wird in der Regel eine elektrochemische Reaktion zwischen Flusssäure und Silizium genutzt, bei der eine schwammartige Struktur im Silizium erzeugt wird. Der Siliziumhalbleiterträger (in der Regel ein Siliziumwafer) muss hierzu gegenüber einem Flusssäureelektrolyt anodisch gepolt sein. Durch die entstandene poröse Struktur erhält das Silizium eine große innere Oberfläche und andere chemische und physikalische Eigenschaften (z.B. geringere Wärmeleitfähigkeit) wie das umgebende Bulk-Silizium. Durch elektrochemisches Ätzen des Siliziums (Anodisieren) in beispielsweise einem Gemisch aus Flusssäure/Ethanol kann poröses Silizium durch teilweises Ätzen in die Tiefe erzeugt werden. Zum Ätzen von Silizium sind Defektelektronen (Löcher) an der Grenzfläche zwischen Silizium und Elektrolyt notwendig, die durch den fließenden Strom bereitgestellt werden. Ist die Stormdichte kleiner als eine kritische Stromdichte, so diffundieren Löcher durch das anliegende elektrische Feld an in der Oberfläche liegende Vertiefungen, in denen ein bevorzugtes Ätzen stattfindet. Bei z.B. p-dotiertem Silizium werden die Bereiche zwischen den Vertiefungen bis zu einer minimalen Dicke lateral geätzt, bis durch Quanteneffekte keine Löcher mehr in diese Bereiche eindringen können und der Ätzvorgang gestoppt wird. Auf diese Weise entsteht eine schwammartige Skelettstruktur aus Silizium und freigeätzten Poren. Da bei der Ausbildung der Skelettstruktur der Ätzvorgang nur im Bereich der Porenspitzen stattfindet, bleibt die Schwammstruktur von bereits geätztem Silizium erhalten. Damit bleibt auch die Porengröße in den bereits geätzten Bereichen nahezu unverändert. Die Porengröße ist abhängig von der HF-Konzentration in der Flusssäure, der Dotierung und der Stromdichte, und kann von einigen nm bis zu einigen *µ*m betragen. Ebenso ist die Porosität in einem Bereich von ca. 10 % bis über 90 % einstellbar.

Für die Herstellung von porösem Silizium können verschieden dotierte Substrate verwendet werden. Üblicherweise verwendet man p-dotierte Wafer mit unterschiedlichen Dotierungsgraden. Durch die Dotierung kann die Struktur innerhalb des porösen Siliziums bestimmt werden.

Für die lokale Herstellung von porösem Silizium gibt es verschiedene Maskierverfahren, wie z.B. die Verwendung von Maskierschichten aus Si_{X}N_{Y}.

Man kann sich aber auch die Erkenntnis zunutze machen, dass p- und n-dotiertes Silizium ein stark unterschiedliches Ätzverhalten aufweisen. Unter den Bedingungen, bei denen im p-dotieren Silizium poröses Silizium erzeugt werden kann, ist dies in n-dotiertem Silizium nicht oder nur in einem sehr geringen Umfang möglich. Zur Festlegung der Sensorelementstrukturen kann daher eine Schicht an der Oberfläche des p-dotierten Substrats n-umdotiert werden (z.B. durch Ionenimplantation oder -diffusion).

Zur Herstellung von Bauelementen wird regelmäßig das poröse Silizium lokal auf einem Siliziumsubstrat in Dicken von mehreren *µ*m bis mehreren 100 *µ*m erzeugt. Durch einen Oxidationsprozess bei Temperaturen von beispielsweise 300 bis 500°C kann das poröse Silizium in seiner Struktur stabilisiert und seine Wärmeleitfähigkeit je nach Porosität und Kristallgröße weiter reduziert werden. Es entsteht oxidiertes poröses Silizium. Anschließend wird bei einer Anwendung das oxidierte poröse Silizium mit einer Deckschicht, z.B. aus CVD-Materialien wie Si_{X}N_{Y}, verschlossen (CVD steht für Chemical Vapour Depostion). Danach lassen sich mittels an sich bekannter Abscheide- und Strukturierungstechniken die aktiven oder sensitiven Elemente, wie z.B. Heizer und/oder Messelemente, über dem porosierten Bereich aufbauen.

Beim "OXOMM"-Verfahren werden durch einen Tiefenätzprozess Gräben von mehreren *µ*m bis mehreren 100 *µ*m in das Silizium geätzt, so dass Siliziumgitter, -stege oder freistehende Siliziumsäulen entstehen. Diese werden vollständig oder nur teilweise aufoxidiert, um deren thermische Leitfähigkeit herabzusetzen.

Danach werden die Gräben regelmäßig durch eine CVD-Schicht verschlossen und die Oberfläche, falls nötig planarisiert, um die aktiven und sensitiven Elemente aufzubringen.

### Aufgabe und Vorteile der Erfindung:

Der Erfindung liegt die Aufgabe zugrunde, Bauelemente, bei welchen thermische Effekte genutzt werden und die einen Halbleitermaterialträger umfassen, bereitzustellen, die im Vergleich zu auf der Basis eines "OxPorSi"- bzw. "OXOMM"-Verfahrens hergestellten Bauelementen verbesserte Eigenschaften besitzen.

Die Erfindung ist in Anspruch 1 definiert und geht zunächst von einem Verfahren zur Herstellung des Bauelementes mit einem Halbleiterträger aus, bei welchem für die Ausbildung von wenigstens einer thermisch entkoppelten Struktur poröses Halbleitermaterial erzeugt wird. Der Kern der Erfindung liegt nun darin, dass im porosierten Material eine Vertiefung oder mehrere Vertiefungen geätzt wird bzw. geätzt werden, um wenigstens einen von durch die eine Vertiefung oder die mehreren Vertiefungen definierten, thermisch entkoppelten Bereich zu erzeugen, und dass über dem wenigstens einen Bereich die mindestens eine Struktur ausgebaut wird.

Dieser Vorgehensweise liegt die Erkenntnis zugrunde, dass sowohl mit dem "OxPorSi"-Verfahren als auch mit dem "OXOMM"-Verfahren hergestellte Bauelemente nicht die Güte einer thermischen Entkopplung einer in BMM-Technologie hergestellten, dielektrischen Membran erreichen, da sowohl durch das OxPorSi als auch durch die Stege vergleichsweise viel Wärme abgeleitet wird. Zum Beispiel wird zum Erreichen einer konstanten Übertemperatur auf 100 µm dickem OxPorSi mit einer Wärmeleitfähigkeit von 0,5 W/mK und 1 mm² Ausdehnung eine 5fach höhere Heizleistung als bei einer in Bulk-Mikro-Mechanik hergestellten Struktur benötigt. Werden beide Verfahren kombiniert, erhält man eine Struktur, die im Vergleich zur reinen OXOMM-Struktur eine deutlich niedrigere vertikale Wärmeleitfähigkeit aufweist und fast ideale laterale Isolationseigenschaften besitzt.

Aus dem porosierten Halbleiter lassen sich durch entsprechende Vertiefungen, z.B. Gräben, Stegstrukturen, matrixartig angeordnete Säulen erzeugen, auf deren Oberfläche die thermisch zu entkoppelten Strukturen aufgebracht werden können.

Eine Stabilisierung und gegebenenfalls weitere Reduktion der vertikalen Leitfähigkeit (also senkrecht zu einem Halbleiterträger) der porosierten Materialbereiche lässt sich dadurch erreichen, dass das hergestellte, porosierte Halbleitermaterial nach dem Einbringen der Vertiefungen, z.B. Gräben, zumindest teilweise oxidiert wird.

Eine Oxidation von porosiertem Halbleitermaterial kann jedoch auch vor dem Ätzen von Vertiefungen erfolgen.

In einer bevorzugten Ausführungsform der Erfindung werden die einen oder mehreren Vertiefungen über eine Dicke des porosierten Materials nur so tief geätzt, dass gerade eine gewünschte laterale thermische Entkopplung stattfindet. Es hat sich gezeigt, dass ein Großteil der Wärme bereits in den ersten 5 bis 30 *µ*m Tiefe der Strukturen abfließt, so dass es für eine gewünschte thermische Funktionalität ausreichend sein kann, das porosierte Material nur über einen entsprechenden Teil der Dicke, z.B. 50 *µ*m, zu strukturieren. Je nach erzeugter Dicke des porosierten Materials können damit Restdicken an porosiertem Material verbleiben.

Zur Herstellung von lokal begrenztem porosiertem Halbleitermaterial können Hart- oder Lackmasken eingesetzt werden. Hartmasken können normalerweise im Schichtaufbau verbleiben, da die Strukturen aus porosiertem Material regelmäßig mit einer isolierenden Deckschicht vor dem Aufbau weiterer Strukturen verschlossen werden.

Um die laterale thermische Entkopplung weiter zu verbessern, ist es überdies vorteilhaft, wenn, insbesondere in dem Fall, in dem die Maskierung im Schichtaufbau verbleibt, diese bei der Strukturierung der porosierten Bereiche durch Ätzen von Vertiefungen unterätzt wird. Durch die verbleibende Maskierung müssen daher obgleich der größeren lateralen Abstände zwischen den porosierten Bereichen keine größeren lateralen Lücken durch die Deckschicht geschlossen werden, denn die Öffnungsweite wird von der Maske bestimmt.

Eine weitere Verbesserung der thermischen Entkopplung lässt sich dadurch erreichen, dass der wenigstens eine durch die eine Vertiefung und/oder mehreren Vertiefungen definierte Bereich aus porosiertem Material im Fußbereich isotrop unterätzt wird. Diese Vorgehensweise lässt sich insbesondere dann bevorzugt einsetzen, wenn das porosierte Material im Hinblick auf die eine oder mehreren Vertiefungen vollständig durchgeätzt ist, so dass im Fußbereich nicht-porosiertes Bulk-Halbleitermaterial vorliegt, das sich mit hoher Selektivität insbesondere zu einer oxidierten, porosierten Struktur ätzen lässt.

Damit lassen sich völlig frei tragende Strukturen erzeugen, die aus Stabilitätsgründen jedoch lateral verankert sein sollten.

Der wesentliche Aspekt des erfindungsgemäß hergestellten Bauelements liegt darin, dass der wenigstens eine porosierte Bereich zum umgebenden Material in lateraler Richtung zumindest teilweise durch einen Hohlraum getrennt ist, der um ein Vielfaches größer ist als die Poren des porosierten Bereichs.

Wie bereits oben erwähnt, lassen sich hierdurch die guten Isolationseigenschaften einer Grabenstruktur in lateraler Richtung durch eine verbesserte vertikale Isolation aufgrund von porosiertem Material kombinieren, wobei nach wie vor insbesondere die gute mechanische Stabilität eines derartigen Aufbaus genutzt werden kann.

Der Aufbau ist besonders dann vorteilhaft, wenn mehrere porosierte Bereiche vorhanden sind, die zumindest in einer Richtung durch Hohlräume getrennt sind. Beispielsweise besitzt das Bauelement eine Vielzahl von Säulen, die zumindest über einen Teil ihrer Höhe porosiert sind. Gegebenenfalls genügt jedoch auch eine Stegstruktur, d.h. eine Struktur, die an gegenüberliegenden Seiten eine laterale Verbindung zum Bulk-Material besitzt.

Eine Optimierung im Hinblick auf eine laterale Isolation eines oder mehrerer porosierten Bereiche lässt sich dadurch erreichen, dass sich der Hohlraum in lateraler Richtung vollständig um den einen oder die mehreren porosierten Bereiche erstreckt. Als Beispiel hierzu kann die bereits oben erwähnte Säulenstruktur genannt werden.

Im Hinblick auf eine vertikale Isolation lässt sich ein Bauteil weiter verbessern, wenn sich der Hohlraum insbesondere zusätzlich auch unter dem einen oder der mehreren porosierten Bereiche erstreckt. Beispielsweise kann eine Säulen- oder Stegstruktur realisiert werden, bei welchem die Säulen oder Stege "frei hängen".

### Zeichnungen:

Mehrere Ausführungsbeispiele der Erfindung sind in den Zeichnungen dargestellt und unter Angabe weiterer Vorteile und Einzelheiten näher erläutert. Es zeigen
- Fig. 1a bis 1c: in jeweils einem schematischen Schnittbild einen Siliziumträger bei der Herstellung eines thermischen Bauelements mit porosierten Bereichen in unterschiedlichen Prozessstadien,
- Fig. 1d: ein zu Fig. 1c vergleichbares Herstellungsstadium, jedoch mit leicht geänderter Prozessführung,
- Fig. 2: ein schematisches Schnittbild eines Siliziumträgers bei der Herstellung eines thermischen Bauelements mit einem Verfahren, bei welchem eine Maske im Schichtaufbau verbleibt,
- Fig. 3: ein schematisches Schnittbild eines zu Fig. 2 entsprechenden Schichtaufbaus, bei welchem jedoch porosierte Strukturen freihängend ausgeführt sind und
- Fig. 4: ein schematisches Schnittbild eines Siliziumträgers in einem weiteren Herstellungsstadium ausgehenden Aufbau gemäß Fig. 1d.

### Beschreibung der Ausführungsbeispiele:

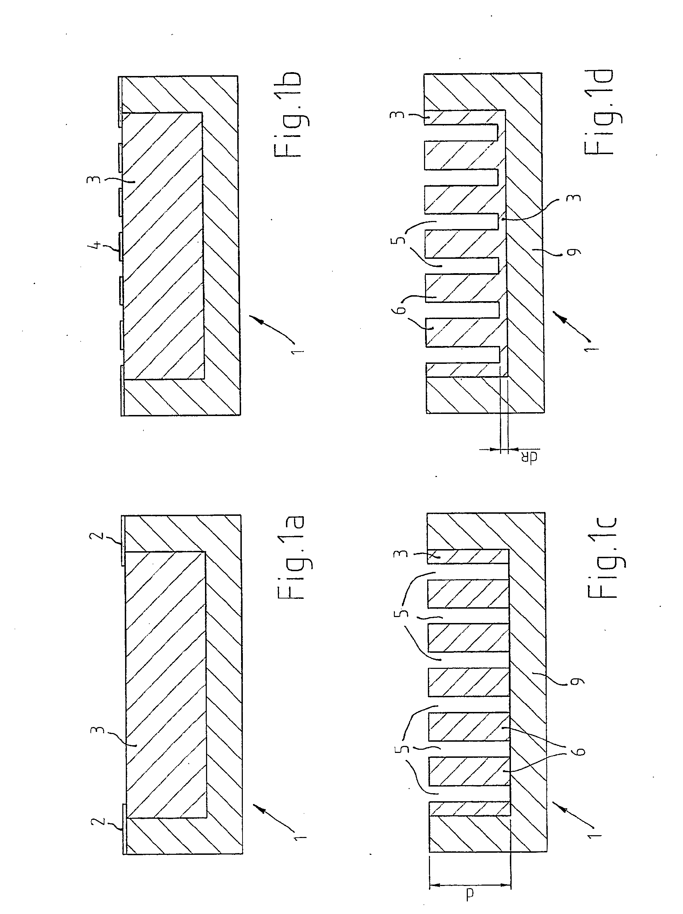

Fig. 1a bis 1c zeigen in jeweils einem schematischen Schnittbild die Entstehung eines thermischen Bauelements auf der Grundlage eines Siliziumwafers 1.

In einem ersten Schritt wird zuerst mittels einer Maske 2 lokal poröses Silizium 3 erzeugt (s. Fig. 1a).

Auf dem porösen Silizium wird eine weitere Maske 4 aufgebracht (s. Fig. 1b), mittels derer Gräben 5 durch einen DRIE-Prozess in das poröse Silizium 3 geätzt werden (s. Fig. 1c). Es verbleiben dementsprechend Stege 6 aus porosiertem Silizium.

Da es sich herausgestellt hat, dass in lateraler Richtung ein Großteil einer Wärmemenge bereits in den ersten 5 bis 30 *µ*m Tiefe von Stegen oder Säulen abfließt, ist es für eine gewünschte thermische Funktionalität gegebenenfalls ausreichend, so wie in Fig. 1d vorzugehen. Hier wurde nicht wie in Fig. 1c das poröse Silizium über seine komplette Dicke d durchgeätzt, sondern lediglich über einen Teil der Dicke d. Dementsprechend verbleibt, wie in Fig. 1d dargestellt, eine Restdicke d_{R} an porösem Silizium. Das hat den Vorteil einer kürzeren Ätzzeit und einer höheren Stabilität der porösen Strukturen.

In Fig. 1c und 1d ist die verwendete Maskierung für die Herstellung des porösen Siliziums und die Erzeugung der Gräben 6 bereits entfernt.

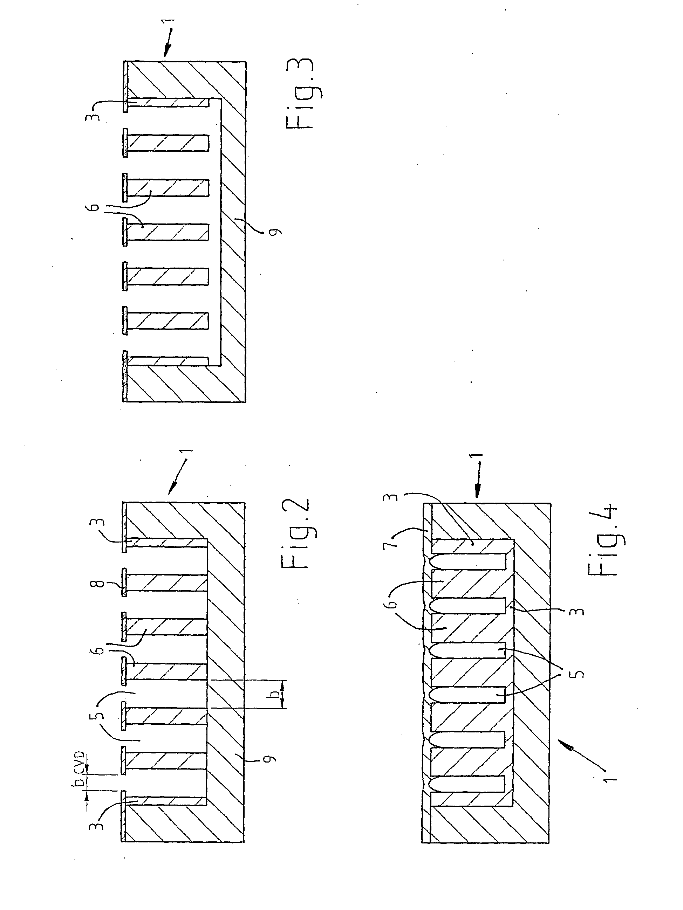

Sofern zur Maskierung jedoch eine "Hart-Maske" (also keine Maskierung aus Fotolack) eingesetzt wird, kann diese im Schichtaufbau sogar vorteilhaft verbleiben. Dies wird insbesondere in Fig. 2 und 3 illustriert.

Bei der Erzeugung der thermischen Strukturen werden regelmäßig die Gräben 6, z.B. durch eine CVD-Schicht (Chemical-Vapour-Deposition-Schicht) verschlossen. Die zum Verschließen notwendige Schichtdicke hängt im Wesentlichen von der Grabenbreite b der Gräben 5 ab.

Eine große Grabenbreite b ist vorteilhaft für eine gute laterale Isolation, aber im Hinblick auf die notwendige Dicke einer Abdeckschicht 7 (s. Fig. 4) von Nachteil.

Durch die verbleibende Maskierung 8 im Schichtaufbau gemäß der Figuren 2 und 3 kann ein Prozess gewählt werden, bei dem die Maskierung 8 gezielt unterätzt wird, um eine Breite b der Gräben 5 zu erreichen. Dennoch ist die für die Abdeckschicht ausschlaggebende Breite b_{CVD} durch die Maske 8 definiert.

Auf diese Weise erhält man somit ausreichend breite Gräben, kann aber trotzdem mit einer vergleichsweise dünnen Abdeckschicht arbeiten, da die diesbezüglich maßgebende Breite b_{CVD} unter der Breite b der Gräben 5 liegt. Das heißt, die minimal notwendige Schichtdicke zum Verschließen ist durch die Breite b_{CVD} der Maskenöffnung der Hart-Maske 8 bestimmt.

Der Unterätzungsgrad kann sehr groß bestimmt werden, wodurch Stege 6 mit geringer Wärmeableitung in die Tiefe und breite Gräben entstehen, die eine nahezu vollständige laterale Isolation gewährleisten. Die effektive Porosität der Struktur wird auf diese Weise erhöht.

Nach einem Prozessstadium gemäß der Figuren 1c, 1d oder 2 wird das poröse Silizium zur Stabilisierung der Poren gegen Hochtemperaturprozesse und zur weiteren Reduktion der Wärmeleitfähigkeit in einer z.B. reinen Sauerstoffatmosphäre bei beispielsweise 300 bis 500°C teiloxidiert. Es entsteht oxidiertes poröses Silizium.

Nach der Oxidation kann bei Varianten gemäß Fig. 1c und Fig. 2 in einer vorteilhaften Weise die thermische Entkopplung noch weiter durch einen isotropen Ätzprozess, z.B. mit XeF₂ oder ClF₃ verbessert werden. Dabei wird die hohe Selektivität des Ätzprozesses zu den mit Oxid umschlossenen porösen Siliziumkristallen ausgenutzt, die ein bevorzugtes Ätzen des Bulk-Siliziums 9 unter dem porösen Silizium 3 (bzw. der porösen Stege oder Säulen 6) erlaubt. Es entsteht eine Struktur gemäß Fig. 3 mit frei hängenden Stegen oder Säulen 6. Aus Stabilitätsgründen eignet sich hierbei nur eine lateral verankerte Säulen- oder Stegstruktur, da die Säulen oder Stege frei hängen.

Vor dem Aufbringen von thermisch zu entkoppelnden Strukturen werden die im porösen Silizium bzw. oxidierten porösen Silizium ausgebildeten Vertiefungen, z.B. bei Stegen in Form von Längsgräben und bei Säulen in Form von Längs- und quergräben, regelmäßig mit einer Deckschicht 7 verschlossen (s. hierzu Fig. 4). Die Deckschicht kann eine CVD-Deckschicht, z.B. eine Siliziumoxidschicht sein.

In Fig. 4 ist der in Fig. 1d abgebildete Herstellungszustand mit Deckschicht 7 dargestellt.

Für den weiteren Aufbau der thermisch zu entkoppelnden Strukturen (nicht dargestellt) kann die Deckschicht noch planarisiert werden.

Die thermisch zu entkoppelnden Strukturen werden vorzugsweise über den verbleibenden porosierten Strukturen, d.h. insbesondere den Säulen oder Stegen aufgebracht.

Die thermisch zu entkoppelnden Bauelemente können aktive oder sensitive Elemente, wie z.B. Heizer, Messwiderstände oder Thermoelemente sein. Insbesondere Heizer und Messwiderstände werden vorzugsweise vollständig über den porosierten Bereichen aufgebracht.

Durch die erfindungsgemäße Vorgehensweise können im Vergleich zu bekannten Prozessen kostengünstigere, robustere und einfacher handhabbarere Sensoren, insbesondere Massenflusssensoren, bereitgestellt werden.

### Bezugszeichenliste:

- 1: Silizium-Wafer
- 2: Maske
- 3: poröses Silizium
- 4: Maske
- 5: Graben
- 6: Stege / Säulen
- 7: Abdeckung
- 8: Maske
- 9: Bulk-Material unter den porösen Strukturen

## Patentansprüche

1. Verfahren zur Herstellung eines Bauelements mit einem Halbleiterträger (1), wobei für die Ausbildung von mindestens einer thermisch entkoppelten Sensor- oder Aktorstruktur
- poröses Halbleitermaterial (3) erzeugt wird,
- im porosierten Material (3) eine Vertiefung oder mehrere Vertiefungen (5) geätzt wird bzw. werden, um wenigstens einen von durch die eine Vertiefung oder die mehreren Vertiefungen definierten, thermisch entkoppelten Bereich (6) zu erzeugen,
- die eine oder mehrere Vertiefungen mit einer Deckschicht (7) verschlossen wird bzw. werden, und
- danach über dem wenigstens einen Bereich (6) die mindestens eine Struktur ausgebildet wird.

2. Verfahren nach Anspruch 1, **dadurch gekennzeichnet, dass** das porosierte Halbleitermaterial nach der weiteren Strukturierung zumindest teilweise oxidiert wird.

3. Verfahren nach Anspruch 1, **dadurch gekennzeichnet, dass** das porosierte Halbleitermaterial vor der weiteren Strukturierung zumindest teilweise oxidiert wird.

4. Verfahren nach einem der vorhergehenden Ansprüche, **dadurch gekennzeichnet, dass** die eine oder mehreren Vertiefungen (5) über eine Dicke d des porosierten Materials (3) geätzt werden, so dass eine gewünschte laterale, thermische Entkopplung stattfindet.

5. Verfahren nach einem der vorhergehenden Ansprüche, **dadurch gekennzeichnet, dass** zur Herstellung der wenigstens einen Vertiefung Hart- oder Lackmasken (4, 8) eingesetzt werden.

6. Verfahren nach Anspruch 5, **dadurch gekennzeichnet, dass** der wenigstens eine Bereich (6), der durch die eine Vertiefung oder die mehreren Vertiefungen (5) definiert wird unter der Maskierung (8) unterätzt wird.

7. Verfahren nach einem der vorhergehenden Ansprüche, **dadurch gekennzeichnet, dass** der wenigstens eine durch die eine Vertiefung oder die mehreren Vertiefungen (5) definierte Bereich (6) aus porosiertem Material im Fußbereich isotrop untergeätzt wird.

## Claims

1. Method for producing a component comprising a semiconductor carrier (1), wherein for the formation of at least one thermally decoupled sensor or actuator structure
- porous semiconductor material (3) is produced,
- one depression or a plurality of depressions (5) is or are etched in the porosified material (3) in order to produce at least one thermally decoupled region (6) defined by the one depression or the plurality of depressions,
- the one or the plurality of depressions is or are closed with a cover layer (7), and
- the at least one structure is then formed above the at least one region (6).

2. Method according to Claim 1, **characterized in that** the porosified semiconductor material is at least partly oxidized after the further structuring.

3. Method according to claim 1, **characterized in that** the porosified semiconductor material is at least partly oxidized before the further structuring.

4. Method according to any of the preceding claims, **characterized in that** the one or the plurality of depressions (5) is or are etched over a thickness d of the porosified material (3) such that a desired lateral, thermal decoupling takes place.

5. Method according to any of the preceding claims, **characterized in that** hard or resist masks (4, 8) are used for producing the at least one depression.

6. Method according to Claim 5, **characterized in that** the at least one region (6) defined by the one depression or the plurality of depressions (5) is undercut below the masking (8).

7. Method according to any of the preceding claims, **characterized in that** the at least one region (6) defined by the one depression or the plurality of depressions (5) and composed of porosified material is isotropically undercut in the base region.

## Revendications

1. Procédé pour la fabrication d'un composant avec un support à semi-conducteurs (1), dans lequel, pour la formation d'au moins une structure de capteur ou d'acteur découplée thermiquement,
- du matériau semi-conducteur poreux (3) est produit,
- une cavité ou plusieurs cavités (5) sont gravées dans le matériau rendu poreux (3) afin de produire au moins une zone (6) découplée thermiquement définie par cette une cavité ou ces plusieurs cavités,
- cette une cavité ou ces plusieurs cavités sont fermées avec une couche de recouvrement (7), et
- ensuite, cette au moins une structure est formée au-dessus de cette au moins une zone (6) .

2. Procédé selon la revendication 1, **caractérisé en ce que** le matériau semi-conducteur rendu poreux est au moins partiellement oxydé après la suite de la structuration.

3. Procédé selon la revendication 1, **caractérisé en ce que** le matériau semi-conducteur rendu poreux est au moins partiellement oxydé avant la suite de la structuration.

4. Procédé selon l'une des revendications précédentes, **caractérisé en ce que** cette une cavité ou ces plusieurs cavités (5) sont gravées sur une épaisseur d du matériau rendu poreux (3) de sorte qu'un découplage thermique latéral souhaité ait lieu.

5. Procédé selon l'une des revendications précédentes, **caractérisé en ce que** l'on utilise des masques durs ou en vernis (4, 8) pour la fabrication de cette au moins une cavité.

6. Procédé selon la revendication 5, **caractérisé en ce que** cette au moins une zone (6), laquelle est définie par cette une cavité ou ces plusieurs cavités (5), est soumise à une gravure sous-jacente sous le masquage (8).

7. Procédé selon l'une des revendications précédentes, **caractérisé en ce que** cette au moins une zone (6) en matériau rendu poreux définie par cette une cavité ou ces plusieurs cavités (5) est soumise à une gravure sous-jacente isotrope dans la zone du pied.
